# EUROPEAN PATENT APPLICATION

(11) **EP 4 394 417 A1**
(43) Date of publication of application: **03.07.2024**
(21) Application number: 22217444.3
(22) Date of filing: 31.12.2022
(51) Int. Cl.: G01R 33/00, G01R 33/02, G01R 33/06, G01R 33/07

(54) **SENSOR DEVICE WITH CIRCUIT AND INTEGRATED COMPONENT FOR MAGNETO-IMPEDANCE MEASUREMENT, AND METHOD OF PRODUCING SAME**

(71) Applicant: Melexis Technologies SA, 2022 Bevaix (CH)
(72) Inventor: DUPONT, Guido, 2022 Bevaix (CH); ROSENFELD, Daniel, 2022 Bevaix (CH); TOMBEZ, Lionel, 2022 Bevaix (CH); BRAJON, Bruno, 2022 Bevaix (CH); VAN DER WIEL, Appo, 3980 Tessenderlo (BE)
(74) Representative: Jacobs, Lambert

(57) **Abstract**

A sensor device comprising: a semiconductor substrate (100) comprising an excitation circuit (101) and a sensing circuit (102) for measuring a magneto-impedance effect of a soft-magnetic component (110) arranged on top of the semiconductor substrate (100); wherein the soft-magnetic component is operatively connected to said excitation circuit and said sensing circuit, and is electrically connected to at least one of said excitation circuit and said sensing circuit by means of back contacts or side contacts; wherein the soft-magnetic component has an elongated shape or an elongated portion extending in a first direction (X) parallel to the semiconductor substrate (100); a processing circuit (506) connected to the sensing circuit, and configured for providing a signal indicative of the measured impedance or a value derived therefrom. A method (263; 2730; 2830) of producing such a semiconductor substrate.

## Description

### Field of the invention

The present invention relates in general to the field of magnetic sensor devices, and more in particular to sensor devices comprising a semiconductor substrate with circuitry for measuring a magneto-impedance effect of a soft-magnetic component integrated on the semiconductor substrate. The present invention is also related to a method of producing such a sensor device.

### Background of the invention

There are various techniques for measuring a magnetic field, for example by making use of the Hall-effect as is typically done in Vertical or Horizontal Hall sensors, or by making use of the magneto-resistive effect as is typically done in magneto-resistive (MR) sensors, or by making use of the magneto-impedance effect as is typically done in magneto-impedance (Ml) sensors. Each of these techniques is known in the art, and has its advantages and disadvantages.

The basic principles of Hall sensors, magneto-resistive (MR) sensors, and magneto-impedance (Ml) sensors are known in the art, and hence need not to be repeated here. Suffice it to say that horizontal Hall elements are capable of measuring a magnetic field amplitude and direction oriented perpendicular to a substrate in which they are implemented, that vertical Hall elements are capable of measuring a magnetic field (amplitude and direction) oriented parallel to a substrate in which they are implemented, and that MR elements and MI sensors are capable of measuring a magnetic field amplitude (but not necessarily also direction) oriented parallel to a substrate in which they are implemented.

EP1076243(A2) and EP1293792(A2) describe magneto-impedance effect elements, and methods of manufacturing them.

There is always room for improvements or alternatives.

### Summary of the invention

It is an object of embodiments of the present invention to provide a magnetic sensor device and a method for producing that sensor device.

It is an object of embodiments of the present invention to provide a sensor device comprising a semiconductor substrate comprising circuitry and an integrated component for magneto-impedance measurement, and to provide a method for producing such a sensor device.

It is an object of embodiments of the present invention to provide a magnetic sensor device that is more compact.

It is an object of embodiments of the present invention to provide a magnetic sensor device with an improved robustness against external influences such as ageing effects and/or temperature changes and/or humidity changes and/or mechanical vibrations and/or centrifugal forces.

It is an object of embodiments of the present invention to provide a magnetic sensor device with an improved shock resistance.

It is an object of embodiments of the present invention to provide a magnetic sensor device having an improved sensitivity and/or having a larger measurement range, e.g. as compared to Hall elements.

It is an object of embodiments of the present invention to provide a magnetic sensor device comprising only a single die.

It is an object of embodiments of the present invention to provide a magnetic sensor device comprising an MI element with a reduced risk of delamination.

It is an object of embodiments of the present invention to provide a magnetic sensor device with a reduced power consumption for a given sensitivity.

These and other objectives are accomplished by embodiments of the present invention.

According to a first aspect, the present invention provides a sensor device comprising: a semiconductor substrate (e.g. a CMOS substrate) comprising an excitation circuit for generating an alternating voltage or an alternating current, and a sensing circuit for measuring magneto-impedance effect of a soft-magnetic component arranged on top of the semiconductor substrate; wherein the soft-magnetic component is operatively connected to both of said excitation circuit and said sensing circuit; and wherein the soft-magnetic component is electrically connected to at least one of said excitation circuit and said sensing circuit by means of back contacts situated at a bottom surface of the soft-magnetic component, and/or by means of side contacts situated near at lateral surface of the soft magnetic component; wherein the soft-magnetic component has an elongated shape extending in a first direction parallel to the semiconductor substrate, or has a shape (e.g. a spiral shape or a meander shape) comprising at least one elongated portion extending in a first direction (e.g. X) parallel to the semiconductor substrate; a processing circuit connected to the sensing circuit, and configured for providing a signal indicative of the magneto-impedance effect or a value derived therefrom (e.g. a magnetic field component Bx, a current, a torque, a position, a pressure).

With "soft-magnetic component " is meant that a component or element that consists of, or mainly comprises a soft-magnetic material, e.g. an element made of a ferro-magnetic material. The "soft-magnetic component" can also be referred to as "integrated MI element" in this application.

The "back contacts" may also be referred to as "bottom contacts". They are situated at a bottom surface of the soft-magnetic component (e.g. as shown in FIG. 1A and FIG. 2A). The "side contacts" are situated near a lateral surface of the soft magnetic component (e.g. as shown in FIG. 15A to FIG. 15C).

Preferably the sensor device is an integrated circuit (so called "chip") encapsulated in a moulded package.

Preferably, the semiconductor substrate is overmoulded in a way such that the ferro-magnetic element is not exposed (after moulding), and is not directly accessible from the outside of the moulded package.

In an embodiment, the soft-magnetic material is a ferromagnetic material, e.g. FeNi or an Fe-Ni alloy.

Preferably, the semiconductor substrate mainly comprises silicon.

Preferably, the semiconductor substrate (not considering the soft-magnetic element), is a "CMOS device", i.e. is produced using a CMOS compatible process.

The "soft-magnetic element" is also referred to herein as "Ml-element".

The "signal indicative of the magneto-impedance effect" may be an impedance value, but that is not absolutely required, but could also be, e.g. a value related to a damped oscillation, e.g. related to the ringing of the waveform of the signal provided by the sensing circuit, e.g. when a rectangular square wave is provided by the excitation circuit.

In an embodiment, at least one of the excitation circuit and the sensing circuit is electrically to the soft-magnetic component.

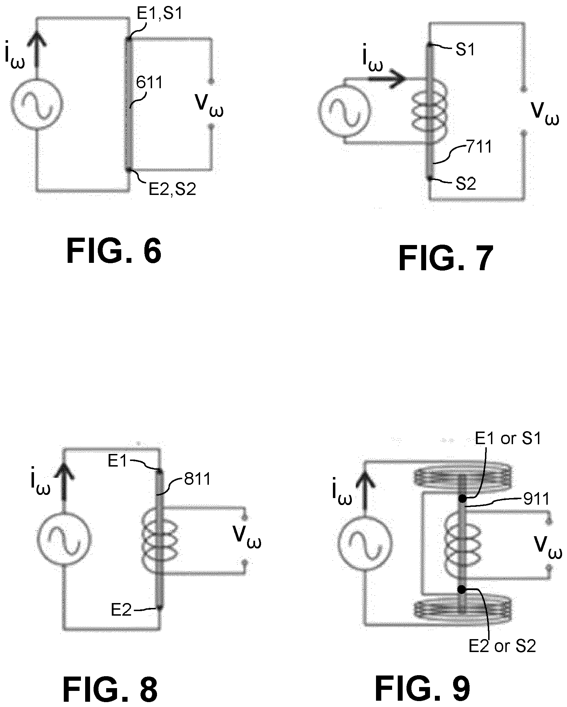

In an embodiment, the excitation circuit is inductively coupled to the soft-magnetic component (e.g. using an excitation coil wound around the soft-magnetic element), and the sensing circuit is electrically connected to the soft-magnetic component (e.g. at a first and a second sensing contact S1, S2), e.g. as schematically indicated in FIG. 7.

In an embodiment, the excitation circuit is electrically connected to the soft-magnetic component (e.g. at a first and a second excitation contact E1, E2), and the sensing circuit is inductively coupled to the soft-magnetic component (e.g. using a sensing coil wound around the soft-magnetic element), e.g. as schematically indicated in FIG. 8.

In an embodiment, the excitation circuit is electrically connected to the soft-magnetic component (e.g. at a first and a second excitation contact E1, E2), and the sensing circuit is electrically connected to the soft-magnetic component (e.g. at a first and a second sensing contact S1, S2), e.g. as schematically indicated in FIG. 6.

In an embodiment, the processing circuit may be, or may comprise a programmable digital processor.

In an embodiment, the semiconductor substrate further comprises a non-volatile memory, operatively connected to the processing circuit. This non-volatile memory may store at least one constant, or may store a look-up table for converting the measured impedance value into a magnetic field value, or into a current value, or into a torque value, etc.

In an embodiment, the impedance measurement involves determining an attenuation and a phase shift between the excitation signal and the sensed signal, e.g. between the applied voltage and the sensed current, or between the applied current and the sensed voltage. The impedance value can be expressed by a complex value having a reel part and a non-zero imaginary part.

In an embodiment, the excitation circuit is electrically connected to the soft-magnetic component at a first and a second excitation contact (e.g. E1, E2); and the sensing circuit is electrically connected to the soft-magnetic component at a first and a second sensing contact (e.g. S1, S2).

In an embodiment, the excitation circuit is configured for applying an alternating voltage to the soft-magnetic element, for causing an alternating current to flow through at least a portion of the soft-magnetic element.

In an embodiment, the excitation circuit is configured for passing an alternating current through the soft-magnetic element, and for measuring an alternating voltage over at least a portion of the soft-magnetic element.

The excitation circuit may be configured for applying an AC voltage or an AC current having a frequency in the range from 10 kHz to 2.0 GHz, or in the range from 10 kHz to 500 MHz, or from 100 kHz to 200 MHz, or from 10 kHz to 100 MHz, or from 50 kHz to 500 MHz, or from 100 kHz to 100 MHz, or from 50 kHz to 50 MHz, e.g. a frequency of at least 10 kHz, or at least 20 kHz, or at least 50 kHz, or at least 100 kHz, or at least 200 kHz, or at least 500 kHz, or at least 1.0 MHz, or at least 2.0 MHz, or at least 5.0 MHz, or at least 10.0 MHz, or at least 20.0 MHz, or at least 50 MHz, and/or at most 1.0 GHz, or at most 500 MHz, or at most 200 MHz, or at most 100 MHz.

In an embodiment, the sensing circuit is configured for measuring an alternating voltage or for measuring an alternating current flowing through at least a portion of the soft-magnetic element.

In an embodiment, the first excitation contact (e.g. E1) coincides with the first sensing contact (e.g. S1) and the second excitation contact (e.g. E2) coincides with the second sensing contact (e.g. S2).

In an embodiment, the first and the second sensing contact (e.g. S1, S2) are situated between the first and the second excitation contact (e.g. E1, E2).

In an embodiment, the excitation contacts may be situated at least 5% or at least 10% or at least 15% of the length of the elongated portion of the Ml-element, from the longitudinal ends of the MI-element.

In an embodiment, the semiconductor substrate further comprises a buffer layer (e.g. a polyimide layer), and the soft-magnetic component is arranged on top of this buffer layer.

It is an advantage of the buffer layer that it may reduce mechanical stress.

In an embodiment, the excitation circuit and the sensing circuit are electrically connected to the soft-magnetic component by means of electrical interconnections passing through the buffer layer.

It is an advantage of electrically connecting the soft-magnetic component "from below", which may be referred to as "bottom contact" or "back-contact", because by doing so, an extra processing step of connecting the soft-magnetic component "from above" (e.g. by means of bond wires) can be avoided, and because it is mechanically more stable.

In an embodiment, the elongated shape or the elongated portion has a length L and a width W parallel to the semiconductor substrate, and a thickness T perpendicular to the semiconductor substrate; and at least one of the ratios L/W and T/W is a value in the range from 2 to 100.

In case of a spiral or a meander, the total length L between the outer ends should be considered, not only a single portion.

In an embodiment, the thickness T is a value in the range from 100 nm to 20 µm. In an embodiment, the thickness is at least 200 nm, or at least 300 nm, or at least 400 nm, or at least 500 nm, or at least 750 nm, or at least 1.0 µm, or at least 1.5 µm, or at least 2.0 µm, or at least 3.0 µm, or at least 4.0 µm, or at least 5.0 µm, or at least 6.0 µm, or at least 8.0 µm, or at least 10.0 µm, or at least 12.5 µm, or at least 15.0 µm, or at least 17.5 µm.

In an embodiment, the thickness T is a value in the range from 5 µm to 25 µm, or from 10 µm to 20 µm.

In an embodiment, the sensor device further comprises a second soft-magnetic component also having at least an elongated portion extending in said first direction (e.g. X), and wherein both soft-magnetic components are excited synchronously (but optionally phase shifted, and optionally differently biased); and wherein output signals from the soft-magnetic components are combined (e.g. summed or subtracted or divided) and indicative of a gradient signal.

In an embodiment, the sensor device further comprises a magnetic shielding that is partially surrounding or completely surrounding the second soft-magnetic element, but not in direct physical contact with the first or second soft-magnetic element.

The purpose of the magnetic shielding is to prevent that the second soft-magnetic component will sense an external magnetic field component Bx, because such magnetic field will mostly pass through the shielding. The impedance measurement of the second soft-magnetic component can be used as a reference to compensate the impedance measurement of the first soft-magnetic component to reduce or eliminate temperature effects, ageing effects or the like.

The magnetic shielding is preferably applied in the same processing step as the soft-magnetic elements, and thus substantially has the same thickness in a direction perpendicular to the semiconductor substrate.

In an embodiment, the sensor device further comprises biasing means for generating a DC magnetic field in the soft-magnetic element.

This embodiment offers the advantage that the characteristic of impedance versus magnetic field to be measured, can be shifted away from the origin, and the sensitivity can be increased.

In an embodiment, the biasing means comprises a coil, e.g. a planar coil, implemented in the so called "metal stack" or "interconnection stack" of the semiconductor device, e.g. of the CMOS device. This coil may comprise one or two or three metal layers. The biasing coil may for example be implemented in a similar manner as the transmitter coil described EP3961926(A1), and illustrated in FIG. 8(a) to FIG. 8(d) thereof, which document is incorporated herein by reference in its entirety, but in the current application, preferably supplied with a DC-current.

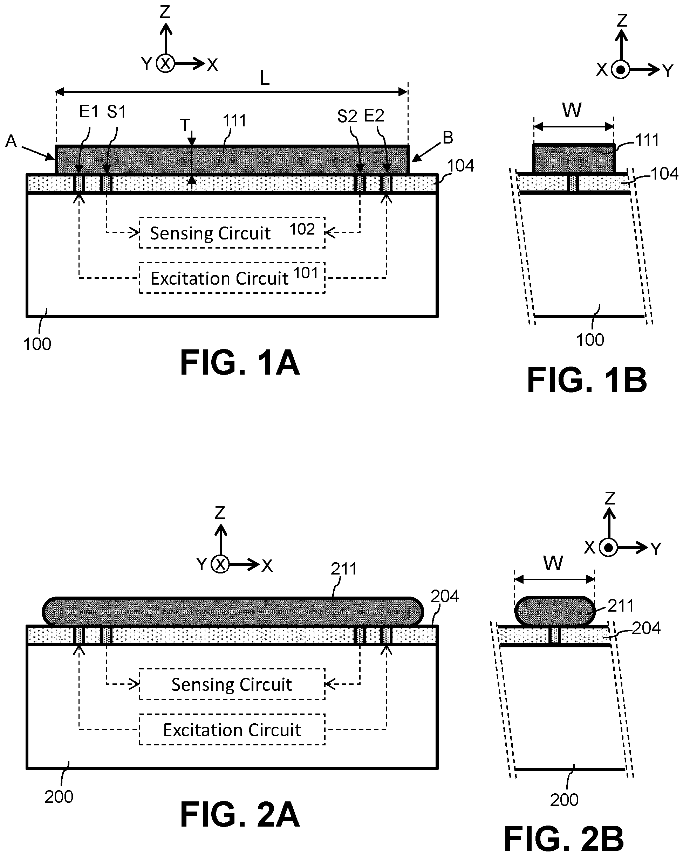

In an embodiment, the soft-magnetic component has a cross-section with rounded or truncated edges or corners. Such embodiments are illustrated in FIG. 2.

In an embodiment, the soft-magnetic component has rounded edges in a plane (e.g. XZ) containing the first orientation (e.g. X) and perpendicular to the semiconductor surface.

In an embodiment, the semiconductor substrate further comprises two soft-magnetic trapezoidal shapes arranged near opposite ends (e.g. A, B) of the soft-magnetic element.

In other words, the elongated portion of the soft-magnetic component is arranged between these two trapezoidal shapes.

The trapezoidal shapes may be integrally formed with the soft-magnetic element, in which case ends of the shape (e.g. ends of the elongated shape, or ends of the spiral, or ends of the meander) contacts the trapezoidal shapes. In this case, preferably, the trapezoidal shapes have the same thickness as the soft-magnetic element. The electrical contacts with the excitation circuit and the sensing circuit may be situated on the trapezoidal shapes, or on the elongated portion, or excitation contacts may be situated on the trapezoidal shapes and the sensing contacts may be situated on the elongated portion.

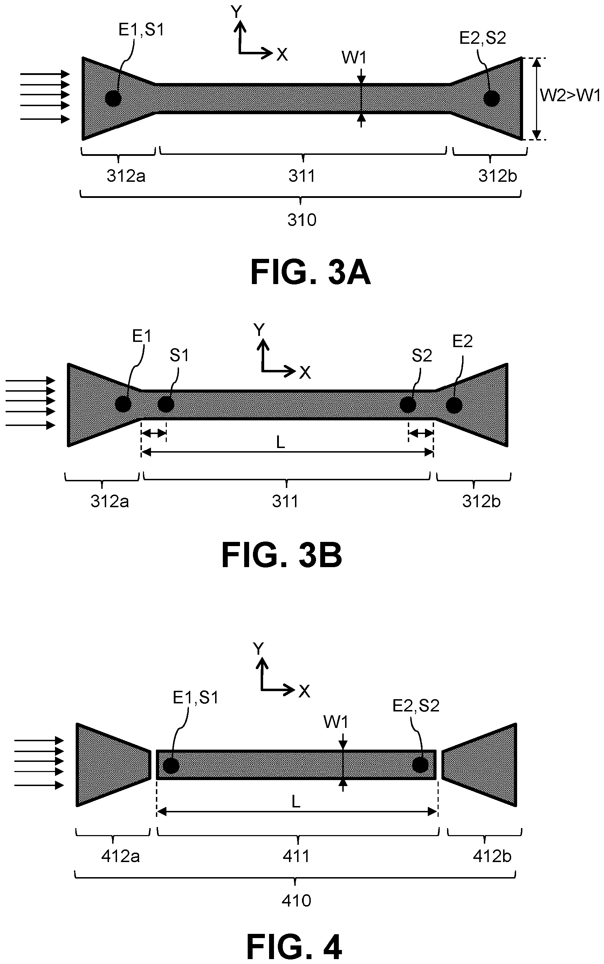

Alternatively, the trapezoidal shapes are spaced from the elongated portion of the soft-magnetic element (e.g. as illustrated in FIG. 4), in which case, there is a small distance between the elongated portion and the trapezoidal shapes.

It is an advantage of this embodiment that the trapezoidal shaped portions function as a magnetic flux concentrator, that the magnetic field component Bx is passively amplified, which further improves the sensitivity of the magneto-impedance measurement, moreover in a passive manner (i.e. without extra power consumption). This is a major advantage, especially for portable applications, such as e.g. an eCompass.

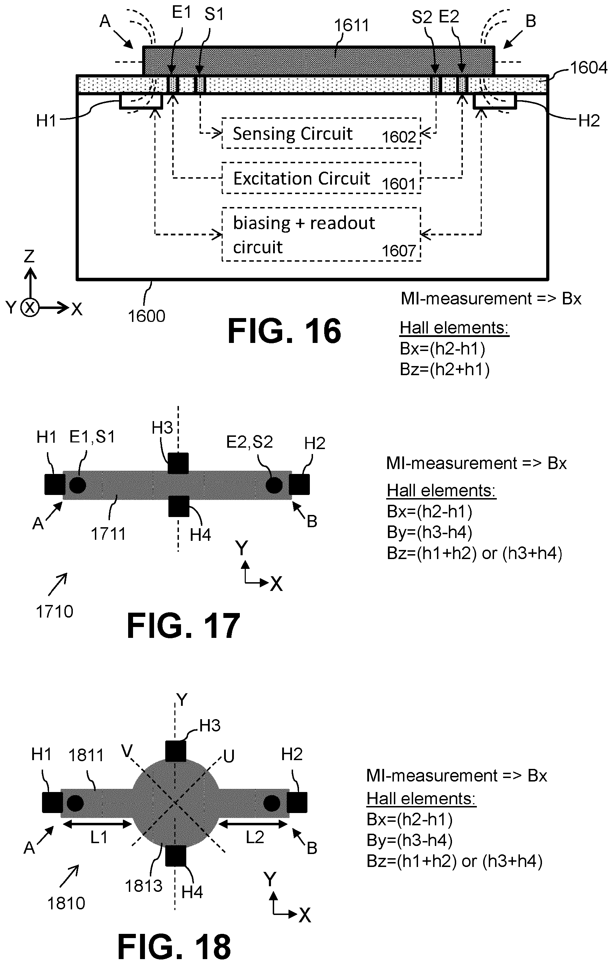

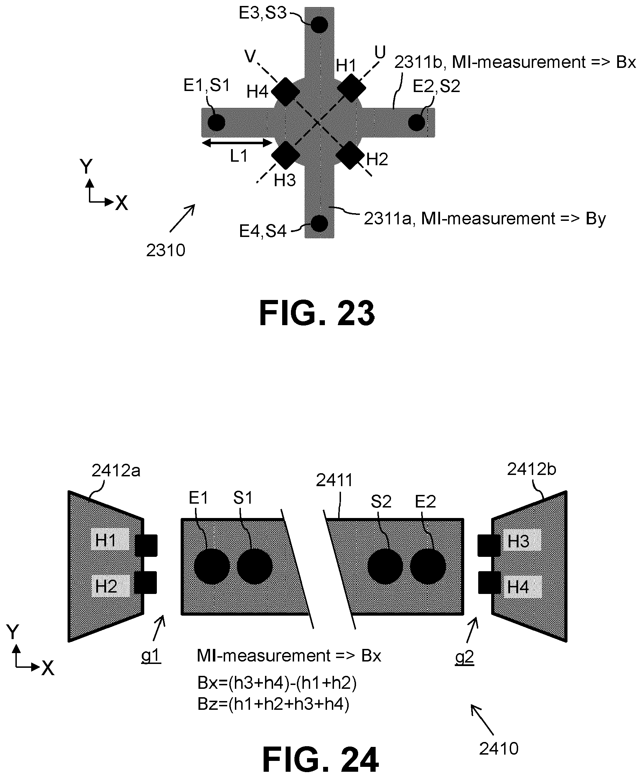

In an embodiment, the semiconductor substrate further comprises at least two horizontal Hall elements (e.g. H1, H2), and the semiconductor substrate further comprises a "biasing and readout circuit" for biasing and reading out these Hall elements; and wherein said horizontal Hall elements are arranged in one of the followings ways: i) near the ends (e.g. A, B) of said soft-magnetic element, e.g. as shown in FIG. 16; ii) near a middle of the soft-magnetic element, on opposite transversal sides of the soft-magnetic component, e.g. situated on a virtual line oriented in a direction (e.g. Y) transversal to the first direction, e.g. as illustrated in FIG. 17 to FIG. 22; iii) near two soft-magnetic trapezoidal shapes arranged near opposite ends of the soft-magnetic element, e.g. as illustrated in FIG. 24.

It is an advantage of this sensor device that it is capable of measuring the magnetic field component Bx in two ways: (1) using these Hall elements, wherein the soft-magnetic component functions as a magnetic field concentrator; and (2) using the magneto-impedance effect of the soft-magnetic element. Since the sensitivity of the Hall elements and of the magneto-impedance measurement are usually very different, this embodiment is capable of measuring magnetic field over an "extended range", i.e. from a relatively weak field to a relatively large field. By comparing the two measurements, an error may be detected, which can be used as a safety-check.

In an embodiment, the sensor device further comprises an integrated magnetic concentrator (IMC) made of a soft-magnetic material, e.g. the same magnetic material as the Ml-element, and wherein the semiconductor substrate comprises a plurality of horizontal Hall elements arranged near a periphery of this IMC.

It is a major advantage that the IMC can be produced in the same processing step as the soft-magnetic element.

According to a second aspect, the present invention also provides a method of producing a semiconductor substrate, the method comprising the steps of: a) providing a semiconductor substrate (e.g. CMOS substrate) comprising: an excitation circuit for exciting a magneto-impedance element; a sensing circuit for sensing a magneto-impedance element; a processing circuit connected to the sensing circuit, and configured for providing a signal indicative of the magneto-impedance effect or a value derived therefrom (e.g. a magnetic field component Bx, a current, a torque, a position, a pressure); b) optionally providing a buffer layer (e.g. a polyimide layer) on top of the semiconductor substrate; c) making at least two (or at least four) openings through an upper layer (e.g. said protection layer or said buffer layer) of the semiconductor substrate, to form excitation contacts (e.g. E1, E2) in electrical connection with the excitation circuit, and/or to form sensing contacts (e.g. S1, S2) in electrical connection with the sensing circuit; d) optionally applying an electrically conductive layer, e.g. a metal seed layer; e) applying a soft-magnetic material, e.g. a ferromagnetic material, e.g. FeNi or an Fe-Ni alloy, e.g. by sputtering and/or by electroplating.

In an embodiment, the method further comprising one of more of the following features: wherein the semiconductor substrate provided in step a) is a CMOS substrate; wherein the semiconductor substrate provided in step a) further comprises at least two horizontal Hall elements, and biasing and readout circuitry for biasing and sensing these horizontal Hall elements; wherein the semiconductor substrate provided in step a) further comprises a non-volatile memory operatively connected to said processing circuit; wherein the method further comprises: forming two trapezoidal portions of said soft-magnetic material, these trapezoidal portions being integrally formed with, or at a non-zero distance from the elongated portion; wherein the method further comprises: forming a disk shaped portion of said soft-magnetic material, this disk shaped portion being integrally formed with, or at a non-zero distance from the elongated portion; wherein the excitation contacts (e.g. E1, E2) coincide with the sensing contacts (e.g. S1, S2); wherein the sensing contacts (e.g. S1, S2) are situated between the excitation contacts (e.g. E1, E2); wherein the semiconductor substrate provided in step a) further comprises a buffer layer on top of the semiconductor substrate; wherein the elongated portion has a length L and a width W parallel to the semiconductor substrate, and wherein the ratio L/W is a value in the range from 2 to 100, or from 5 to 20; wherein the elongated portion has a length L and a thickness T perpendicular to the semiconductor substrate, and wherein the ratio L/T is a value in the range from 2 to 100, or from 5 to 20; wherein at least two shapes having an elongated portion are formed in step d); wherein at least two shapes having an elongated portion are formed in step d), and wherein one of these shapes is at least partially surrounded by a magnetic shielding; wherein the semiconductor substrate further comprises a planar coil, having a plurality of windings routed below the elongated portion; further comprising a step of wet etching or anisotropic etching after applying the soft-magnetic material, in order to provide rounded or truncated ends and/or edges; wherein the method further comprises a step f) of annealing the soft magnetic material while applying a static magnetic field oriented in a direction parallel to the semiconductor substrate; wherein the method further comprises a step of creating an easy magnetization axis by flowing a relatively large current through the soft-magnetic element. (e.g. a current larger than 1 Ampère).

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

**FIG. 1A and FIG. 1B** show an embodiment of a semiconductor substrate, and a magneto-impedance (Ml) element integrally formed on top of the semiconductor substrate, according to an embodiment of the present invention.
**FIG. 2A and FIG. 2B** show a variant of the embodiment of FIG. 1A and FIG. 1B, wherein the MI element has rounded or truncated ends and/or edges.
**FIG. 3A and FIG. 3B** shows a bottom view of an MI-structure having an elongated portion and two trapezoidal portions integrally formed with the elongated portion. In **FIG. 3A** the sensing contacts coincide with the excitation contacts. In **FIG. 3B** the sensing contacts are situated between the excitation contacts. The electrical contacts are shown as black circles, but are actually located at a bottom side of the IMC structure (e.g. as can be appreciated from FIG. 1A and FIG. 1B).
**FIG. 4** shows a sensor structure comprising an elongated portion, and two trapezoidal portions spaced from the elongated portion.

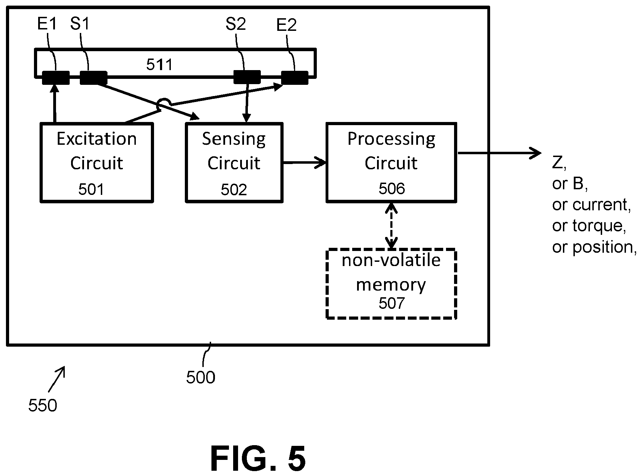

**FIG. 5** shows a functional block-diagram of a sensor device proposed by the present invention, with an abstract representation of the MI structure having two excitation contacts and two sensing contacts.
**FIG. 6 to FIG. 9** schematically illustrate that the MI structure can be excited electrically or magnetically, and can be sensed electrically or magnetically. In addition, the MI-structure may be biased magnetically.

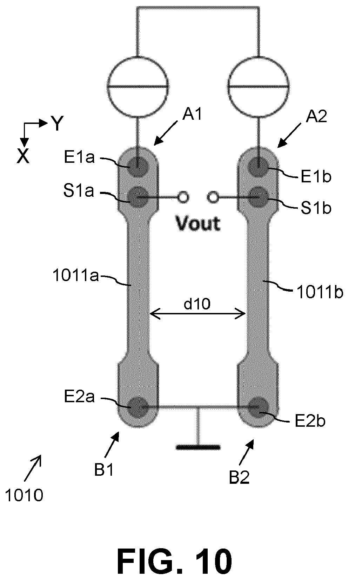

**FIG. 10** shows a sensor structure as may be used in embodiments of the present invention, comprising two identical elongated elements arranged mechanically in parallel.

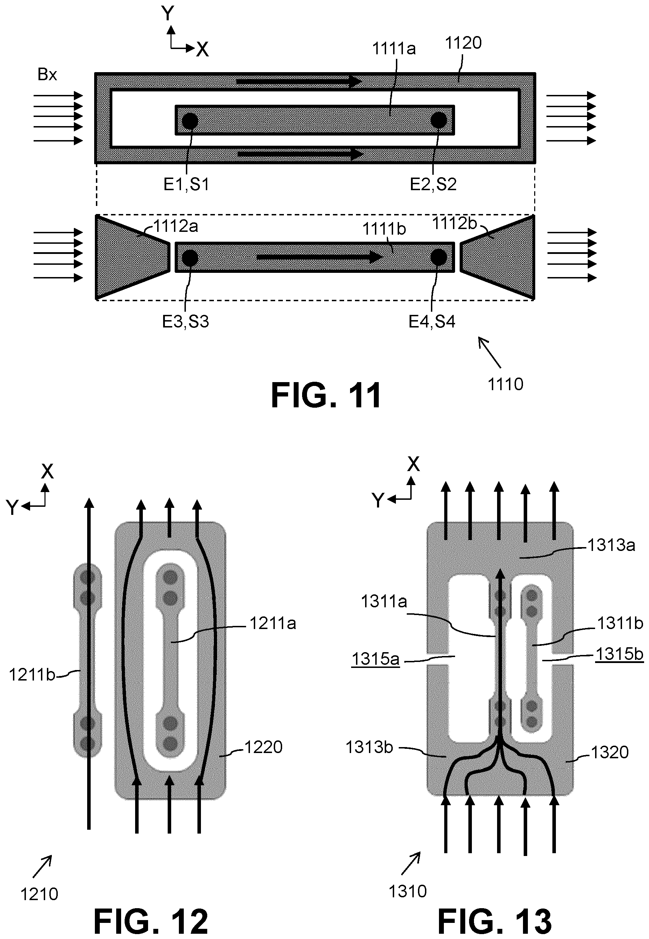

**FIG. 11 to FIG. 13** show sensor structures as may be used in embodiments of the present invention, comprising two elongated elements, one of which is at least partially magnetically shielded.

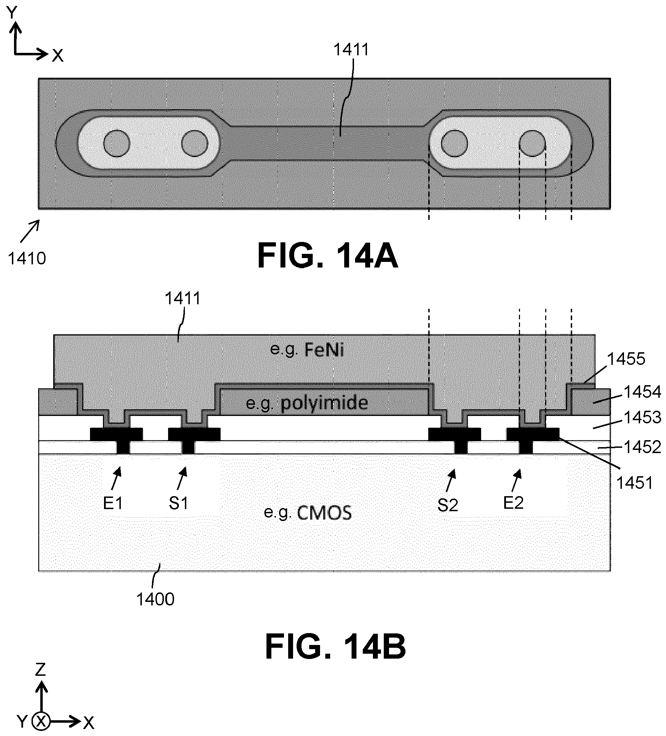

**FIG. 14A and FIG. 14B** show a top view and a cross-sectional view of a sensor device according to another embodiment of the present invention, having a single opening through the polyimide layer at each end of the Ml-element (thus 2 openings for a single MI-element), each opening accommodating an excitation contact and a sense contact, the opening being substantially filled with soft-magnetic material.

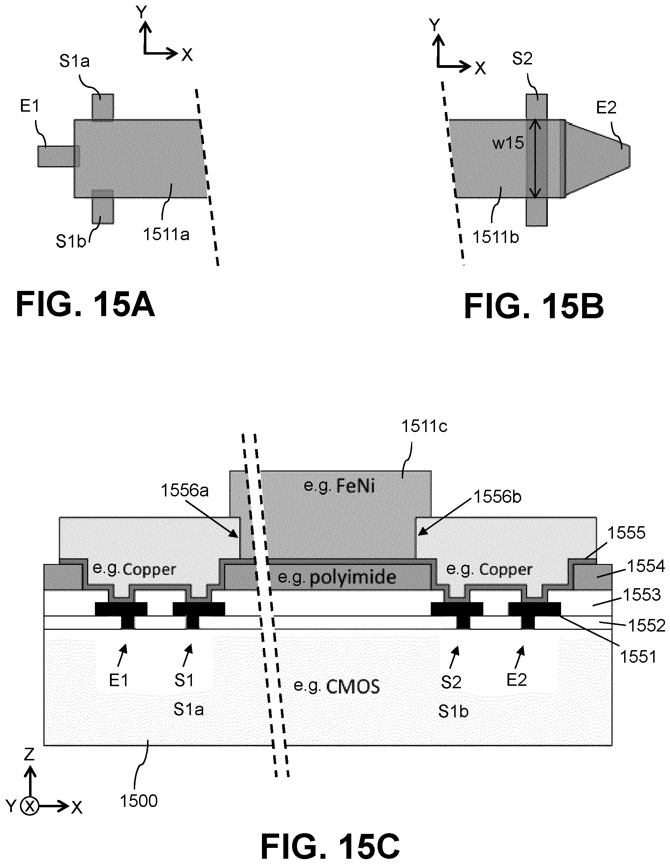

**FIG. 15A** shows a top view of an Ml-element having an excitation contact and two sense contacts contacting the Ml-element from its side surface(s), as may be used in embodiments of the present invention. *(only one end is shown)*
**FIG. 15B** shows a top view of an Ml-element having an excitation contact surface situated at one side end of the Ml-element, and having a sense contact surface situated at the bottom of the MI-element, but extending over the entire width of the MI-element, as may be used in embodiments of the present invention. *(only one end is shown)*
**FIG. 15C** shows a variant of FIG. 14B, where the openings through the polyimide layer are substantially filled with an electrically conductive material (e.g. Cu), in contact with the MI-element from its side-surface(s), as may be used in embodiments of the present invention.
**FIG. 16** shows a variant of FIG. 1, wherein the semiconductor substrate further comprises two horizontal Hall elements arranged near the ends of the elongated portion.
**FIG. 17** shows a sensor structure as can be used in embodiments of the present invention, comprising an MI element having an elongated portion, and two Hall elements arranged near the middle of the elongated portion, on opposite transversal sides thereof.
**FIG. 18** shows a sensor structure as can be used in embodiments of the present invention, comprising an MI element having an elongated portion, and a disk shaped magnetic flux concentrator integrally formed with, and located in the middle of the elongated portion, and two horizontal Hall elements arranged near the periphery of the flux concentrator, and two horizontal Hall elements arranged near the ends of the elongated portion.

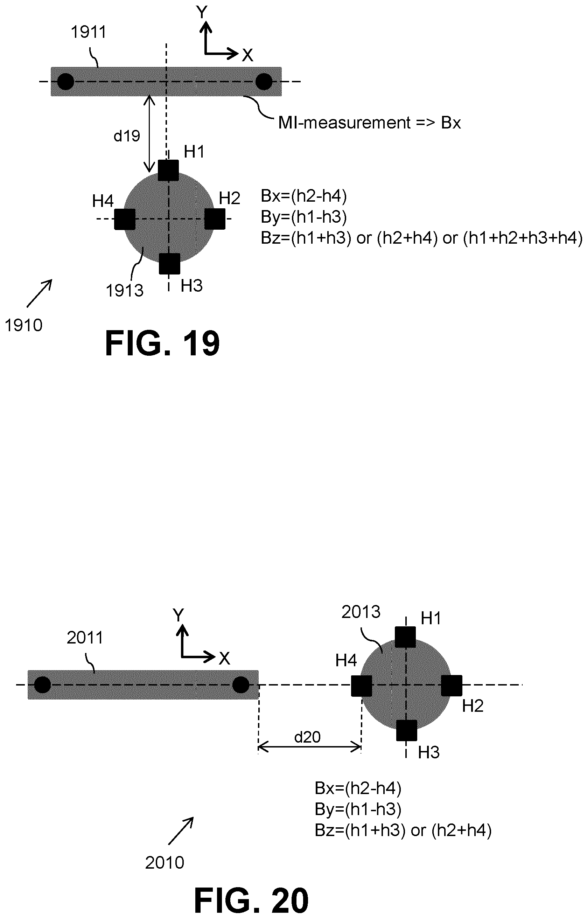

**FIG. 19** and **FIG. 20** show sensor structures as can be used in embodiments of the present invention, comprising an MI element having an elongated portion, and a disk shaped magnetic flux concentrator, spaced apart from the elongated portion, and a plurality of Hall elements arranged near the periphery of the disk shaped flux concentrator.

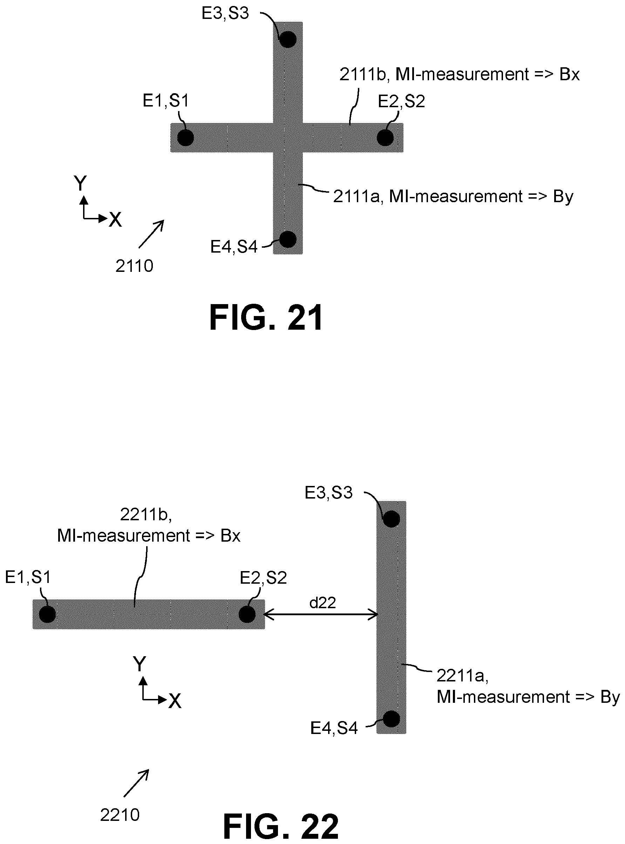

**FIG. 21** shows a sensor structure as can be used in embodiments of the present invention, comprising two elongated portions, oriented perpendicular to each other, and integrally formed.
**FIG. 22** shows a sensor structure as can be used in embodiments of the present invention, comprising two elongated portions, oriented perpendicular to each other, spaced apart from each other.
**FIG. 23** shows a variant of FIG. 21, further comprising a disk shaped magnetic flux concentrator integrally formed with the elongated portions, and four horizontal Hall elements arranged near the periphery of the disk shaped portion.
**FIG. 24** shows a sensor structure as can be used in embodiments of the present invention, comprising an MI structure having an elongated portion and two trapezoidal portions, and Hall elements arranged between the trapezoidal portions and the elongated portion.

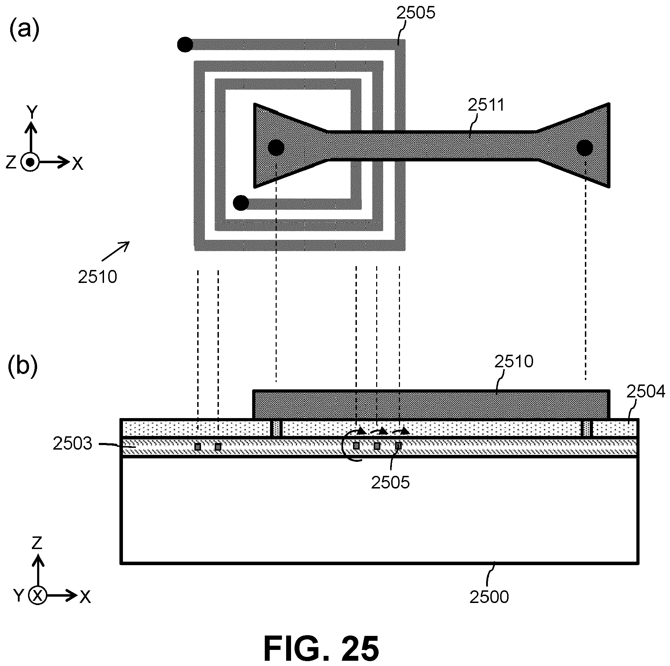

**FIG. 25** shows an example of a sensor structure comprising an elongated portion, and a planar coil configured for magnetically biasing the elongated portion.

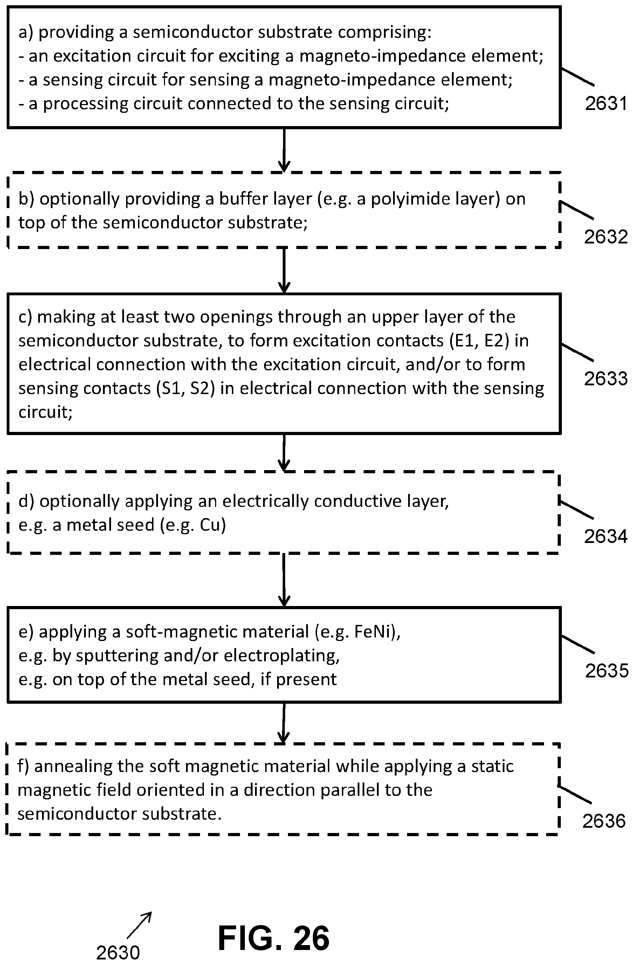

**FIG. 26** shows a flow chart of a method according to the present invention, which can be used to manufacture a semiconductor substrate as described above, e.g. as illustrated in FIG. 1A or FIG. 2A.

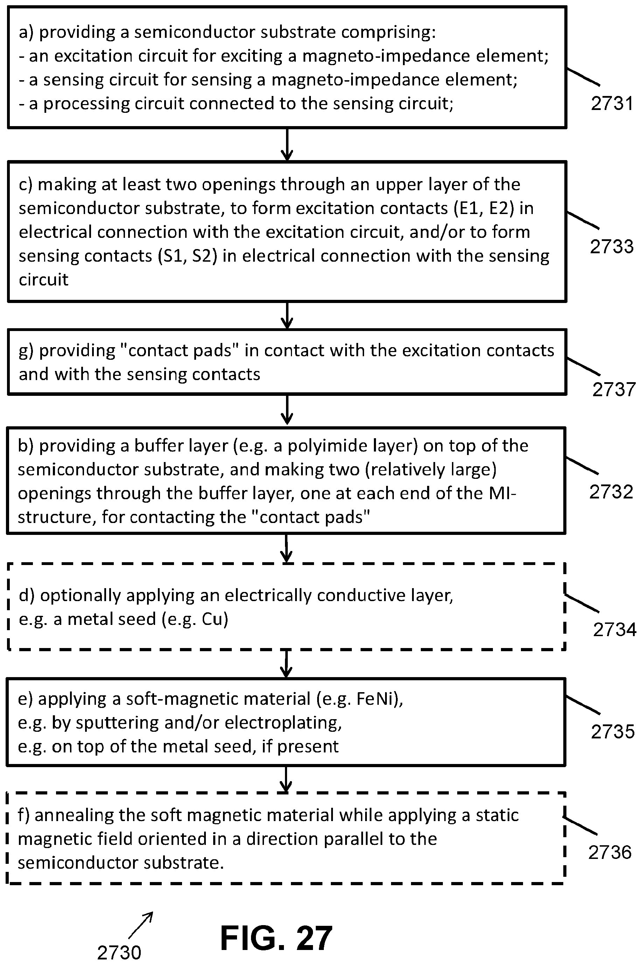

**FIG. 27** shows a flow chart of a method according to another embodiment of the present invention, which can be used to manufacture a semiconductor substrate as described above, e.g. as illustrated in FIG. 14A and FIG. 14B.

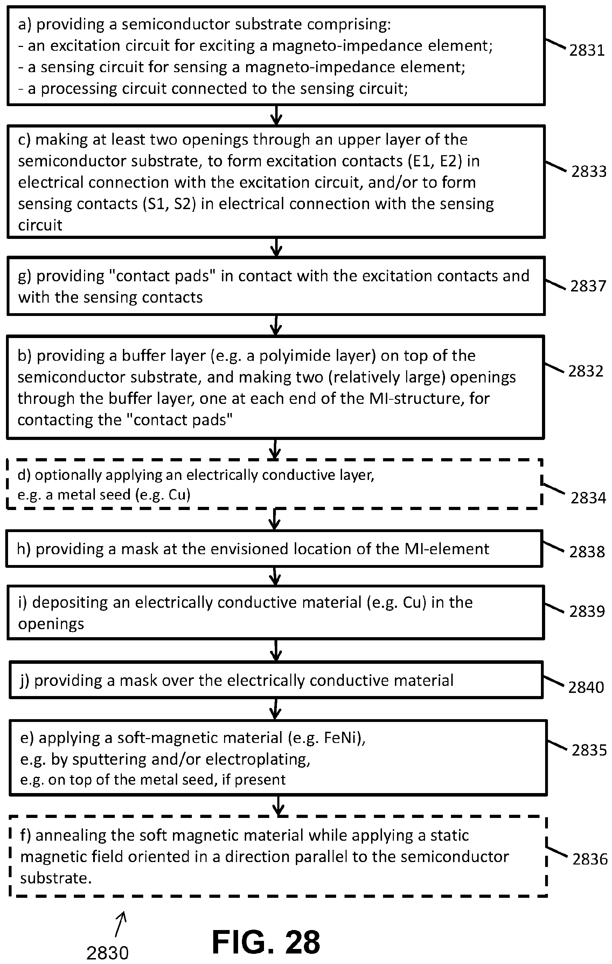

**FIG. 28** shows a flow chart of a method according to another embodiment of the present, which can be used to manufacture a semiconductor substrate as described above, e.g. as illustrated in FIG. 15A to FIG. 15C.

The drawings are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

The terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

In this document, unless explicitly mentioned otherwise, the term "magnetic sensor device" or "sensor device" refers to a device comprising at least one "magnetic sensor" or at least one magnetic "sensor element", preferably integrated in a semiconductor substrate. The sensor device may be comprised in a package, also called "chip", although that is not absolutely required.

In this document, the term "sensor element" or "magnetic sensor element" or "magnetic sensor" can refer to a component or a group of components or a sub-circuit or a structure capable of measuring a magnetic quantity, such as for example a magneto-resistive (MR) element, a GMR element, an XMR element, a horizontal Hall plate, a vertical Hall plate, a Wheatstone-bridge containing at least one (but preferably four) magneto-resistive elements, a magneto-impedance (MI) element, a giant magneto-impedance (GMI) element, etc. or combinations hereof.

In embodiments of the present invention, the term "magnetic sensor structure" may refer to a single "magnetic sensor element", or to an arrangement comprising at least two "magnetic sensor elements", e.g. one or more Ml-elements and optionally one or more integrated magnetic flux concentrators.

In this document, the expression "in-plane component of a magnetic field vector" and "projection of the magnetic field vector in the sensor plane" mean the same. If the sensor device is or comprises a semiconductor substrate, this also means a "magnetic field component parallel to the semiconductor plane". These components may be labelled Bx, By.

In this document, the expression "out-of-plane component of a magnetic field vector" and "Z component of the vector" and "projection of the vector on an axis perpendicular to the sensor plane" mean the same. This component may be labelled Bz.

Embodiments of the present invention are typically described using an orthogonal coordinate system which is fixed to the sensor device, and having three axes X, Y, Z, where the X and Y axis are parallel to the substrate, and the Z-axis is perpendicular to the substrate. In embodiments of the present invention comprising an MI element having an elongated portion, the elongated portion typically extends in the X-direction.

In this document, the expression "magneto-impedance component" or "magneto-impedance element" are used as synonyms.

In this document, the expression "spatial derivative" or "derivative" or "spatial gradient" or "gradient" are used as synonyms. If the order of the derivative is not explicitly mentioned, a first order gradient is meant, unless clear from the context otherwise. In the context of the present invention, the gradient is typically determined as a difference between two values measured at two locations spaced apart along a certain direction. In theory the gradient is typically calculated as the difference between two values divided by the distance between the sensor locations, but in practice the division by said distance is often omitted, because the measured signals need to be scaled anyway. Hence, in the context of the present invention, the expression "magnetic field difference" and "magnetic field gradient" can be used interchangeably.

In this application, horizontal Hall plates are typically referred to by H1, H2, etc., signals obtained from horizontal Hall plates are typically referred to by h1, h2, etc., vertical Hall plates are typically referred to by V1, V2, etc., and signals obtained from vertical Hall plates are typically referred to by v1, v2, etc.

In this document, the term "contact pad" may refer to a "surface area" of the semiconductor die, comprising or electrically connected to one or more of the metal layers of the "metal stack" of the semiconductor device. A "contact pad" may involve all four metal layers M1, to M4 of the metal stack of a CMOS die, locally interconnected by a plurality of vias, but that is not absolutely required for the present invention.

The present invention is related to the field of magnetic sensor devices, and more in particular to sensor devices comprising a semiconductor substrate (e.g. a CMOS substrate) with circuitry for measuring a magneto-impedance effect of a soft-magnetic component integrated on the semiconductor substrate. The present invention is also related to a method of producing such a sensor device.

**FIG. 1A and FIG. 1B** show cross-sections of a semiconductor substrate 100, and a magneto-impedance element 111 integrally formed on top of the semiconductor substrate 100. The magneto-impedance element 111 is also referred to herein as Ml-element or Ml-component.

The MI-element 111 has an elongated shape extending in a first direction X, parallel to the semiconductor substrate. The X-direction is also referred to as the "longitudinal direction". A second axis Y, also referred to herein as "transversal direction" or "width direction" is oriented parallel to the substrate 100 and perpendicular to the X-axis. A third axis Z, also referred to herein as "height direction" is oriented perpendicular to the substrate 100. FIG. 1A shows a longitudinal cross-section of the Ml-element 111 in the plane XZ. FIG. 1B shows a transversal cross-section of the Ml-element in the plane YZ.

Preferably, the semiconductor substrate 100 (without the MI-element) is a "CMOS device", i.e. is produced using a CMOS compatible process. The semiconductor substrate 100 comprises an excitation circuit 101, and a sensing circuit 102 for measuring a magneto-impedance effect of the MI-element 111. Such circuits are known in the art, are not the main focus of the present invention, and hence need not be explained in full detail here. It suffices to say that the excitation circuit 101 may be configured to generate an alternating voltage signal or a pulsed voltage signal, e.g. a sinusoidal voltage signal having a predefined amplitude and a predefined frequency, or to generate an alternating current signal or a pulsed current signal, e.g. a sinusoidal current signal having a predefined amplitude and a predefined frequency. The frequency may be in the range from 10 kHz to 2.0 GHz, or in the range from 10 kHz to 500 MHz, or from 100 kHz to 200 MHz, or from 10 kHz to 100 MHz, or from 50 kHz to 500 MHz, or from 100 kHz to 100 MHz, or from 50 kHz to 50 MHz.

The semiconductor substrate 100 may further comprise a processing circuit (not explicitly shown in FIG. 1A) connected to the sensing circuit, and configured for providing a signal indicative of the measured impedance or a value derived therefrom, e.g. a magnitude of a magnetic field component Bx, a current value, a torque value, a linear or an angular position, a distance value, etc.

According to underlying principles of the present invention,
- the MI-element 111 mainly comprises a soft-magnetic material, or is made of a soft-magnetic material, e.g. a ferromagnetic material, e.g. FeNi or an Fe-Ni alloy;
- the MI-element 111 is arranged, e.g. deposited on top of the semiconductor substrate 100, e.g. directly on top of the semiconductor substrate, or on top of a buffer layer 104, e.g. a polyimide layer. Typically, a plurality of openings need to be made in the CMOS substrate, and if a buffer layer 104 is also present, the plurality of openings also needs to be made in the buffer layer, e.g. by etching. The MI element 111 may be applied by sputtering and/or by electroplating. The "metal stack" may contain an electrically conductive "seed layer" functioning both as an etch stop, and as a basis for growing the soft-magnetic material. Alternatively, a seed layer and/or one or more electrically conductive buffer layers may be sputtered on top of the CMOS substrate. The dimensions of the Ml-element may be defined by lithographical processes. The thickness of the MI element may be defined by the duration of the sputtering or electroplating step, or in other suitable ways. It is noted that a seed layer and/or one or more other electrically conductive buffer layers are needed only when the soft-magnetic material is deposited by electroplating, but the present invention is not limited thereto. If the soft-magnetic material is deposited only by sputtering, the seed layer and/or one or more electrically conductive buffer layers may be omitted.
- the MI element 110 is electrically connected to said excitation circuit 101 and to said sensing circuit 102 by means of at least two (e.g. only two, or four) electrical contacts E1, S1, E2, S2. In FIG. 1A these contacts are situated at a bottom side of the MI element 110, in which case they are also referred to herein as "back contacts" or "bottom contacts", but the present invention is not limited thereto, and it is also possible to connect the MI-element to the excitation circuit and the sensing circuit via "side-contacts" (e.g. as illustrated in FIG. 15A to FIG. 15C). In this way, electrical connections at the top, e.g. by means of bond wires can be avoided, thus extra processing steps can be avoided. Furthermore, the "back-contacts" or "side contacts" also provide a very firm mechanical anchoring of the MI-element, such that the risk of delamination is strongly reduced or substantially eliminated.

The semiconductor substrate 100 with the MI-element 111 may be mounted on a lead frame (not shown) or on a base for a BGA package etc., and/or may be overmoulded by a moulding compound (not shown), so as to form a packaged sensor device, also referred to as "chip".

The excitation circuit 101 of FIG. 1A is electrically connected to the MI-element 111 by means of two "bottom contacts" or "back-contacts" E1, E2, spaced apart over a first non-zero distance along the X-direction. The sensing circuit 102 is electrically connected to the Ml-element 111 by means of two "bottom contacts" or "back-contacts" S1, S2, spaced apart over a second non-zero distance along the X-direction. The second distance may be smaller than the first distance, or may be equal to the first distance, e.g. in case the excitation contacts and the sensing contacts coincide (e.g. as illustrated in FIG. 3A, FIG. 4, FIG. 11, etc.). The second distance may be at least 150 µm, or at least 200 µm, or at least 250 µm, or at least 300 µm, or at least 400 µm, or at least 500 µm, or at least 750 µm, or at least 1000 µm.

In the example of FIG. 1A, the sensing contacts S1, S2 are located between the excitation contacts E1, E2, but that is not absolutely required, because the sensing contact S1 and the excitation contact E1 may coincide. Likewise, the sensing contact S2 and the excitation contact E2 may coincide. Thus, the Ml-element 111 may have two back contacts or side contacts (if S1 coincides with E1, and S2 coincides with E2), or three back contacts or side contacts (e.g. if S1 coincides with E1, but S2 does not coincide with E2) or four back contacts or side contacts (e.g. if S1 and E1 are separate contacts, and S2 and E2 are separate contacts).

The excitation contacts E1, E2 may be offset from the outer ends A, B of the soft-magnetic element 111 in the longitudinal direction, e.g. at least L*3%, or at least L*5%, or at least L*10%, or at least L*15%, where L is the length of the MI-element in the longitudinal direction. In this way, the risk of a non-uniform current density due to side effects and/or surface defects near the edges or near the outer ends of the Mi-structure, can be reduced or avoided.

In the example of FIG. 1A and FIG. 1B, the Ml-element 111 is beam-shaped with a length L in the X-direction (longitudinal direction), a width W in the Y-direction (transversal direction), and a height H in the Z-direction (height direction).

In an embodiment, the ratio L/W is a value in the range from 2 to 100.

In an embodiment, the ratio L/W is a value of at least 2.0, or at least 5.0, or at least 10.0, or at least 20, or at least 30, or at least 40, or at least 50, e.g. when using spirals or meanders.

In an embodiment, at least one of the ratios L/W and T/W is a value in the range from 5 to 20, e.g. in the range from 8 to 18, e.g. in the range from 10 to 15. In preferred embodiments, both ratios L/W and T/W are in the range from 5 to 20. This is beneficial for the skin effect, and thus for the impedance measurement.

In the example of FIG. 1A and FIG. 1B the Ml-element 111 has "straight edges", but that is not absolutely required.

A method which can be used to produce a sensor device as illustrated in FIG. 1A, will be discussed further (see FIG. 26).

**FIG. 2A and FIG. 2B** show a variant of the embodiment of FIG. 1A and FIG. 1B, wherein the MI element 211 has rounded or truncated ends (e.g. as illustrated in FIG. 2A), and/or has rounded or truncated edges (e.g. as illustrated in FIG. 2B). This can be achieved for example by wet etching. By providing rounded or truncated edges and/or rounded or truncated ends, discontinuities in the current density near the outer periphery of the MI-element can be avoided, which is beneficial to the MI-effect. Everything else described above, is also applicable here, mutatis, mutandis.

**FIG. 3A** shows an MI element in the form of a magnetic structure 310 having an elongated portion 311 and two trapezoidal portions 312a, 312b integrally formed with the elongated portion 311. In the example shown, the elongated portion 311 has a constant width W1. The two trapezoids have a short side oriented in the Y-direction, both having the same width W1, and have a long side oriented in the Y-direction, having a width W2 larger than W1, e.g. at least 20% larger, or at least 40% larger, or at least 50% larger. Preferably the ratio W2/W1 is a value in the range from 120% to 250%, e.g. in the range from 150% to 200%. Importantly, the "large sides" of the trapezoids 312a, 312b are straight and are oriented in the transversal direction Y. They offers the advantage of passively amplifying the magnetic field component Bx sensed by the elongated portion 311. This increases the sensitivity of the MI element (for a given electrical power), or decreases the power consumption (for a given sensitivity). This also increases the signal-to-noise ratio of the MI-sensor.

In the example of FIG. 3A, the excitation contact E1 and the sensing contact S1 coincide and are located on the trapezoidal shape 312a, but that is not absolutely required. In fact, whether or not the excitation and sensing contacts coincide is unrelated to the presence or absence of the trapezoidal portions.

In another embodiment (not shown), the contacts E1 and S1 coincide at a first contact location, and the contacts E2 and S2 coincide at a second contact location, and both the first and second contact location are situated on the elongated portion 311.

In another embodiment (not shown), each of the contacts S1 and S2 is situated between the contacts E1 and E2, and all contacts E1, S1, E2, S2 are situated on the elongated portion 311.

In yet another embodiment, illustrated in **FIG. 3B**, the excitation contacts E1 and E2 are located on the trapezoidal shapes 312a and 312 respectively, but the sense contacts S1 and S2 are located on the elongated portion 311. In the example shown, the sense contacts S1, S2 are slightly offset from the ends of the elongated portion 311, e.g. by approximately 3% to 8% of L, e.g. by about 5% of L, L being the length in the X-direction of the Ml-element without the trapezoidal portions.

**FIG. 4** shows a variant of the MI element of FIG. 3A and FIG. 3B, where the two trapezoidal portions 412a, 412b are spaced from the elongated portion by a small distance (e.g. about 1 µm). The trapezoidal shapes 412a,b are still magnetically coupled to the elongated portion 411, and provide an increased magnetic field vector Bx to the elongated portion 411, but the trapezoidal shapes are electrically separated therefrom. All the contacts E1, E2, S1, S2 are located on the elongated portion 411. In the example shown in FIG. 4A, the contacts E1 and S1 coincide at a first contact location, and the contacts E2 and S2 coincide at a second contact location, but that is not absolutely required.

In a variant of FIG. 4, the sensing contacts S1 and S2 are located between the excitation contacts E1, E2, e.g. 5% or 10% or 15% of the length L inwards.

The elongated shape 411 has a thickness T. Preferably the trapezoidal shapes 412a,b have the same thickness T. Such a structure 410 is easier to produce. But it is also possible to provide trapezoidal shapes with a thickness larger or smaller than the thickness of the elongated shape 411, e.g. by electroplating either the elongated shape 411 but not the trapezoidal shapes, or vice versa.

**FIG. 5** shows a functional block-diagram of a sensor device 540 proposed by the present invention. The sensor device 540 comprises an excitation circuit 501, and a sensing circuit 502 for performing an impedance measurement. The sensor device further comprises a magneto-impedance element 511, represented in an abstract manner as a block having two excitation contacts E1, E2 and two sensing contacts S1, S2. The sensor device 540 further comprises a processing circuit 506 connected to the sensing circuit 502, and configured for providing a signal indicative of the measured impedance or a value derived therefrom, e.g. a magnetic field component Bx, a current, a torque, a position, a pressure, etc., depending on the application in which the sensor device 550 is used. The processing circuit 506 may comprise analog or a digital circuitry. The sensor device 550 may optionally further comprise a non-volatile memory 507, operatively connected to the processing circuit. This non-volatile memory 507 may store at least one constant, or may store a look-up table for converting the measured impedance value into a magnetic field value, or into a current value, or into a torque value, or into a pressure value, or into a distance value, etc.

While not shown in FIG. 5, the sensor device 550 may be a packaged semiconductor device, (also known as "chip"), comprising a semiconductor substrate with an MI element, optionally with a lead frame, and preferably overmoulded by a plastic mould compound.

In embodiments of the present invention described above, the MI-element 611 is electrically connected to the excitation circuit via excitation contacts E1, E2, and is electrically connected to the sensing circuit via sensing contacts S1, S2, as schematically illustrated by **FIG. 6**.

But that is not the only possible way to excite and to sense the Ml-element, however, as schematically illustrated in **FIG. 7** where the MI-element 710 is sensed electrically but excited magnetically, or as illustrated in **FIG. 8** where the MI element 810 is excited electrically but sensed magnetically, or as illustrated in **FIG. 9** where the MI element 910 is excited magnetically and sensed electrically, or excited electrically and sensed magnetically, and where one of the coils is used for magnetic biasing. In fact, a MI-element can also be magnetically biased, for example by any of the coils illustrated in FIG. 7 to FIG. 9, or by means of an additional coil.

**FIG. 10** shows a sensor structure 1010 comprising two identical soft-magnetic elongated elements 1011a, 1011b, arranged in parallel (in a direction sensitive to Bx), and spaced apart by a distance d10, e.g. in the range from 100 µm to 2000 µm, or in the range from 100 µm to 1000 µm, or in the range from 200 µm to 800 µm, or in the range from 100 µm to 500 µm, e.g. equal to about 200 µm, or equal to about 300 µm. The two MI elements 1011a, 1011b are preferably electrically interconnected at their ends B1, B2 to a fixed voltage potential, e.g. to a reference voltage (GND). When the two Ml-elements 1011a, 1011b are synchronously excited by an AC source (e.g. a sinusoidal current), or by related sources (e.g. synchronous sinusoidal currents with different or equal phases, or related pulses, and/or same, opposite or different DC bias current), a voltage difference Vout measured between the sensing nodes S1a and S1b is indicative of a magnetic field gradient of the Bx component along the Y-direction, which may be written as dBx/dy. The sensor of FIG. 10 is thus in fact a differential sensor (also known as a gradiometer).

**FIG. 11** shows a sensor structure 1110 as may be used in embodiments of the present invention, comprising two elongated elements 1111a, 1111b, both oriented in the X-direction. As can be appreciated from FIG. 11, the first elongated element 1111a is surrounded by a substantially planar object made of a soft-magnetic material in the same plane as the first elongated element 1111a, but open at its top and its bottom side. In the example of FIG. 11, the shielding 1120 has an overall rectangular shape, but that is not absolutely required. The object 1120 acts as a magnetic shielding for magnetic field lines parallel to the semiconductor surface, and oriented in the X-direction. The height (in the Z-direction) of the rectangular shape 1120 may be smaller than, substantially equal to, or larger than the height of the first elongated element 1111a, e.g. at least 20% larger, or at least 30% larger. The second elongated element 1111b preferably has the same size and dimensions as the first elongated element 1111a, but is not surrounded by a shielding. Instead, two trapezoidal shapes 1112a, 1112b made of a soft-magnetic material, are arranged at a small distance from the elongated shape 1111b. As suggested by the dotted lines, preferably the corners of the trapezoidal shapes 1112a and 1112b define a virtual rectangle having the same size (length and width) as the rectangular shielding object 1120.

Each elongated element 1111a, 1111b is an Ml-element, the magneto-impedance of which can be measured independently. In an embodiment, each MI element has its own excitation circuit and sensing circuit, and the MI elements may be operated simultaneously. In another embodiment, there is only one excitation circuit and only one sensing circuit, which is selectively applied to either the first MI element or the second MI element. The result obtained from the first and second MI element can be used in a differential measurement, implemented in analog or digital circuitry. By calculating a sum, or a difference, or a ratio, a common mode effect can be reduced or removed (e.g. a temperature influence, or long-term drift). Indeed, in the absence of a magnetic field signal Bx, the two MI elements 1111a, 1111b will have a very similar behaviour, which can be regarded as a common mode signal. In the presence of a magnetic field signal Bx, the second MI element 1111b will measure an impedance which varies with Bx, whereas the first MI element 1111a will measure an impedance which does not substantially vary with Bx. By subtracting the signals, or by calculating a ratio, a common mode component which is experienced by both MI elements, e.g. a temperature dependence, or a drift over lifetime, can be reduced or eliminated.

In the example shown in FIG. 11, the excitation contacts E1, E2, E3, E4 coincide with the respective sensing contacts S1, S2, S3, S4, but that is not absolutely required, and in a variant of FIG. 11, the sensing contacts S1, S2 may be located between the excitation contacts E1, E2, and the sensing contacts S3, S4 may be located between the excitation contacts E3, E4.

As pointed out above, FIG. 11 is not necessarily drawn to scale, and in practice, a distance between the MI element 1111a and the shielding 1120 may be increased to avoid leakage.

**FIG. 12** shows a magnetic structure 1210, which can be considered a variant of FIG. 11, having a first and a second MI element 1211a, 1211b of equal size and shape, each having an elongated portion with rounded ends but no trapezoidal portions. The elongated portion of the first MI-element 1211a is surrounded by a substantially rectangular shape 1220, made of a soft-magnetic material having rounded corners, functioning as a shielding. The elongated portion of the second MI element 1211b is not surrounded by a shielding. Again, the signals obtained from these elements may be added, or subtracted, or my be divided in the analog or digital domain. By doing so, a common influence, or relative influence which is shared by both MI elements, such as e.g. a temperature dependence, or a drift over lifetime, can be reduced or substantially eliminated.

**FIG. 13** shows a magnetic structure 1310, which can be considered another variant of FIG. 11 and FIG. 12, having a first and a second elongated portion 1311a, 1311b of substantially the same size and shape. The first elongated portion 1311a is connected in the middle between two U-shaped portions 1313a, 1313b, oriented such that the legs of the U-shaped portions are oriented towards each other but without touching each other, so as to form two cavities 1315a, 1315b. The second MI-element 1311b is situated inside one of these cavities 1315b. The U-shaped portions 1313a, 1313b function as a magnetic field concentrator or passive amplifier for the first MI-element 1311a, (e.g. similar to the trapezoidal shapes described above), but at the same time, function as a magnetic shielding for the second elongated portion 1311b. Again, by summing or subtracting or by calculating a ratio of the signals obtained from the two MI elements, a common mode can be reduced or avoided.

**FIG. 14A and FIG. 14B** show a top view and a cross-sectional view, respectively, of a sensor device 1410 which can be regarded as a variant of the sensor device of FIG. 1A, or FIG. 2A, or FIG. 5. The main purpose of FIG. 14A and FIG. 14B is to illustrate and describe another way of connecting the MI element 1411 to the excitation and sensing circuit (not explicitly shown) of the semiconductor substrate, e.g. CMOS substrate 1400.

A method to produce a sensor device as illustrated in FIG. 14A and FIG. 14B, will be described further in FIG. 27, but as can already be appreciated from FIG. 14B, the sensor device 1410 is based on a CMOS device with a passivation layer 1452 or 1453 and with contact pads 1451. On top of the CMOS device a buffer layer 1454, e.g. a polyimide layer may be applied; a first relative large opening is made in the buffer layer above the contact pads E1, S1, and a second relatively large opening is made in the buffer layer above the contact pads E2, S2, and four relatively small openings are made to expose the contact pads 1451. Then a conductive seed layer 1455 may be sputtered, and a soft magnetic material (e.g. FeNi or a FeNi alloy) may be applied on top of the seed layer, e.g. by electroplating. As can be seen, the relatively large openings are thus mainly filled with the soft-magnetic material 1411, and the MI element 1411 thus formed, has four "back contacts" or "bottom contacts".

It is an advantage that there has to be one one (relatively large) opening through the buffer layer, e.g. polyimide-layer, on each side of the Ml-element, even if the excitation contact does not coincide with the sensing contact.

It is an advantage that the contact pads are made by the CMOS process (with high position accuracy), and that the position tolerances of the opening through the buffer layer can be relaxed.

**FIG. 15A** shows a top view of an MI-element 1511a having an excitation contact E1 and two sense contacts S1a, S1b contacting the MI-element 1511a from its side surface(s). Only one end of the MI-element 1511a is shown in FIG. 15A, but of course, the opposite end of the MI element could be connected in a similar way. The top view of FIG. 15A may be considered/interpreted together with the cross-sectional view of FIG. 15C, or a variant thereof.

**FIG. 15B** shows a top view of an MI-element 1511b having a trapezoidal shaped excitation contact surface E2 situated at one end of the MI-element, and having a rectangular shaped sense contact surface S2 situated at the bottom of the MI-element 1511b, but extending over the entire width w15 of the Ml-element. It is an advantage that the contact interface is not a small location, but is a larger area. In this way the contact resistance can be reduced, and the accuracy of the MI-measurement can be improved. Only one end of the MI-element 1511b is shown in FIG. 15B, but of course, the opposite end of the MI element could be connected in a similar way. The top view of FIG. 15B may be considered/interpreted together with the cross-sectional view of FIG. 15C, or a variant thereof.

**FIG. 15C** shows a variant of FIG. 14B. A method to produce a sensor device as illustrated in FIG. 15C in conjunction with FIG. 15A or FIG. 15B, will be described further in FIG. 28, but as can already be appreciated from FIG. 15C, the sensor device 1510 is based on a CMOS device with a passivation layer 1552 or 1553 and with contact pads 1551. On top of the CMOS device a buffer layer 1554, e.g. a polyimide layer is applied; a first relative large opening is made in the buffer layer above the contact pads E1, S1, and a second relatively large opening is made in the buffer layer above the contact pads E2, S2, and four relatively small openings are made to expose the contact pads 1551. Then a conductive seed layer 1555 may be sputtered. In contrast to the device of FIG. 14B, the soft magnetic material is not applied yet, but first a mask is applied in a region between the two relatively large openings, and the openings are mainly filled with a conductive material, such as e.g. copper (Cu). Then the material in the intermediate region is removed, and a soft magnetic material (e.g. FeNi or a FeNi alloy) is applied, on top of the seed layer, e.g. by electroplating. As can be seen, the relatively large openings are thus mainly filled with the non-magnetic material (e.g. Cu), and the MI element 1511 thus formed may have two or more side contact surfaces 1556a, 1556b. In this way, the direction of the current flowing through the soft-magnetic material during actual use of the MI-measurement, can be better controlled, and the current can be made more uniform.

FIG. 15C shows a cross-section in the plane XZ, but a similar cross-section (without the contacts E1, E2 can be used in the plane YZ, especially in conjunction with FIG. 15A.

In a variant, FIG. 15a contains a plurality of side-contacts adjacent the Ml-element, and these side-contacts are interconnected in the CMOS-device below the Ml-element, and copper zones may be provided on top of each such side contact, and the copper zones may then also be interconnected above the Ml-element, e.g. using an RDL-layer, or a 3D RDL, or using bond-wires. In this way, a coil can be formed around the MI-element.

In FIG. 15C, the soft-magnetic material 1511c is thicker than the copper layers, but that is not absolutely required, and in a variant, the copper layers may be thicker than the soft-magnetic material.

**FIG. 16** shows an embodiment of a sensor device comprising a semiconductor substrate 1500, e.g. a CMOS substrate, comprising an MI element 1611 having an elongated portion extending in the X-direction, and two horizontal Hall elements H1, H2 arranged near the longitudinal ends A, B of the elongated portion, and integrated in the semiconductor substrate 1600. This sensor device can be seen as a variant of the sensor device of FIG. 1A, with the addition of two Horizontal Hall elements H1, H2, and a "biasing and readout" circuit 1607 for biasing and reading out the Horizontal Hall elements. But of course, two horizontal Hall elements may also be added to the sensor device of FIG. 14A to FIG. 15C.

Everything else described above is also applicable here. For example, the sensing contacts S1, S2 may or may not coincide with the respective excitation contacts E1, E2; the elongated portion of the MI element 1610 may have rounded or truncated ends or edges; the semiconductor substrate 1600 may comprise two Ml-elements arranged mechanically in parallel (as in FIG. 10); the semiconductor substrate 1600 may comprise two MI elements arranged mechanically in parallel, but electrically disconnected, one of which may be surrounded by a planar shielding, as illustrated in FIG. 11 to FIG. 13.

The main benefit of these embodiments is that the magnetic field component Bx can not only be measured by the Ml-element 1611, but can also be measured by the Horizontal Hall elements H1, H2, wherein, moreover, the soft-magnetic element 1611 functions as a flux concentrator, thus as a passive amplifier. Furthermore, the horizontal Hall elements H1, H2 also allow to measure a component of the magnetic field oriented in direction Z perpendicular to the semiconductor substrate, for example in accordance with the following formulas: Bx ^{∼} (h2-h1), and Bz^{∼}(h1+h2), where the symbol ^{∼} means: "is proportional to", and h1 and h2 are the signals obtained from the first and second Hall element H1, H2 respectively.

This device allows to measure the magnetic field component Bx with a first sensitivity determined by the Ml-element 1611, and with a second sensitivity determined by the Hall elements. The combination allows redundancy, and/or an extended range. The Horizontal Hall elements also allow to determine the direction of the magnetic field, which may not be possible using the Ml-element alone.

**FIG. 17** shows an example of another sensor structure 1710 that can be used in embodiments of the present invention. The sensor structure 1710 comprises an elongated MI element 1711 made of a soft-magnetic material, e.g. a ferromagnetic material, e.g. FeNi or an Fe-Ni alloy; and further comprises four Hall elements H1, H2, H3, H4. Two Hall elements H1, H2 are arranged near the longitudinal ends A, B of the elongated portion 1711. The other two Hall elements H3 and H4 are arranged near the middle of the elongated portion 1711, on opposite sides of the elongated portion, opposite each other in the transversal direction Y.

The Ml-element allows to measure a magnetic impedance, corresponding to a magnitude of the magnetic field component Bx. The two black circles represent the excitation contacts E1, E2 and the sensing contacts S1, S2, but as explained above, the sensing contacts S1, S2 do not need to coincide with the excitation contacts, and may be located between the excitation contacts, or may actually be side contacts.

The Hall elements allow to measure three magnetic field components Bx, By, Bz, e.g. using the following formulas: Bx^{∼}(h2-h1); By^{∼}(h3-h4); Bz^{∼}(h1+h2) or Bz^{∼}(h3+h4) or Bz^{∼}(h1+h2+h3+h4). It is an advantage that the soft-magnetic material of the Ml-element functions as a flux concentrator for the Bx-field lines, thus as a passive amplifier.

Providing two different measurement principles, namely an MI-measurement and a measurement with Hall elements provides an extended range, and/or provides redundancy which can be used for fault-detection, e.g. by comparing the two measurements of Bx.

In an embodiment, the measurement of the MI element and of the Hall elements is performed simultaneously. In another embodiment, the measurement of the MI element and of the Hall elements is not performed simultaneously, but is performed e.g. in a time-multiplexed manner.

**FIG. 18** shows an example of another sensor structure 1810 that can be used in embodiments of the present invention. The sensor structure 1810 of FIG. 18 can be seen as a variant of the sensor structure 1710 of FIG. 17. The sensor structure 1810 comprises a disk shaped portion having a diameter D, and two elongated portions of length L1, L2 extending in opposite directions of the disk. Preferably the diameter D is a value in the range from about 100 µm to about 300 µm, e.g. equal to about 200 µm. The elongated portions have a length L1, L2, which are preferably equal, and preferably the sum of length L1 plus L2 is at least 6 times the diameter D, which can be written mathematically as: (L1+L2) ≥ 6^{∗}D. The magnetic structure 1610 is integrally formed, and is made of a soft-magnetic material, e.g. a ferromagnetic material. In the example shown, two Horizontal Hall elements H1, H2 are arranged near the ends A, B of the elongated elements, and two horizontal Hall elements H3, H4 are arranged near the periphery of the disk shaped portion. Everything else mentioned above for FIG. 17 is also applicable here, mutatis mutandis.

In a variant of FIG. 18 (not explicitly shown), four horizontal Hall elements are located near the periphery of the disk, on virtual lines U, V forming an angle of 45° with the X-direction, angularly spaced apart by multiples of 90°, and the Hall elements H3 and H4 on the Y-axis may be omitted.

**FIG. 19** shows an example of another sensor structure 1910 that can be used in embodiments of the present invention. The sensor structure 1910 comprises a disk shaped flux concentrator 1913 (also referred to as "IMC disk"), and an elongated MI-element 1911. The disk 1913 and the MI-element 1911 comprise the same soft-magnetic material, and are preferably produced simultaneously. As can be seen, the MI element is oriented in the X-direction, and the disk 1913 is located on the midline of the MI element 1911, i.e. on a virtual line passing through the middle of the Ml-element 1911 and oriented in the Y-direction. In the example shown, there are four horizontal Hall elements H1 to H4 arranged near the periphery of the disk 1913, two of them H2, H4 being located on virtual line parallel to the X-axis, the other two H1 and H3 being located on said midline. The disk 1913 is spaced from the MI-element 1911 by a predefined distance d19, e.g. in the range from 100 um to 400 um. In a variant of the sensor structure 1910, only two Hall elements are present, e.g. only H2 and H4 are present, or only H1 and H3 are present.

Besides offering two measurements of the magnetic field Bx, and thus an extended range and redundancy as described above, this sensor structure also provides a measurement of the magnetic field components By and Bz. In order to get an accurate measurement of Bx, By, Bz, the MI-circuit may be disabled during measurement of the Hall elements.

The sensor structure 1910 offers the further advantage that the measurements of the Hall elements H1 to H4 can be used to test correct functioning of the excitation circuit and the MI element 1911. In order to simplify this evaluation, the excitation circuit of the Ml-element may have a normal operation mode, during which an alternating voltage or current is supplied to the MI-element 1911 (as described above) and may have a diagnostics mode during which a predefined dc voltage or current is supplied to the Ml-element. This dc current, when flowing through the MI-element 1911, will generate a magnetic field that can be measured by the horizontal Hall elements. By comparing the measured field, with the expected field, an error can be detected.

In a particular embodiment, the test comprises the following steps:
i) measuring Bz while the MI element 1911 is disabled (to measure an external disturbance field);
ii) shortly thereafter, measuring Bz while the MI element 1911 is provided with the dc test current (to measure a superposition of the external disturbance field and the field generated by the MI-element,
iii) subtracting the result of the first measurement from the second measurement, thereby obtaining a measurement of the field generated by the Ml-element 1911 in diagnostics mode;
iv) comparing the measured field with the predefined field using a predefined matching criterium (e.g. deviation should be smaller than a predefined threshold), and determining whether an error is detected based on the outcome of that comparison.

**FIG. 20** shows an example of another sensor structure 2010 that can be used in embodiments of the present invention. As can be seen, it comprises the same elements as the sensor structure 1911 of FIG. 19, but the disk 2013 with the Hall elements is arranged on the same axis as the MI element.

It is an advantage of this sensor structure that the MI element and IMC disk can be designed with different magnetic properties, e.g. to sense different ranges of magnetic field (e.g. high saturation for the IMC and low saturation for the MI element). This allows to build a sensor with extended range, and/or allows to detect errors for safety purposes.

In a variant of this embodiment, the Hall elements H2 and H4 are omitted, the MI-element 2011 is used for measuring Bx, and H1 and H3 are used for measuring By and Bz.

In another variant of this embodiment, the Hall elements H1 and H3 are omitted, and a first measurement of Bx is provided by the Ml-element, and a second measurement of Bx is provided by H2 and H4.

**FIG. 21** shows an example of another sensor structure 2110 that can be used in embodiments of the present invention. As can be seen, it comprises two elongated MI-elements 2111a, 2111b oriented in perpendicular directions. These Ml-elements are integrally formed, and are thus electrically and magnetically interconnected at the center.

In an embodiment, the first MI-element 2111b (oriented in the X-direction) and the second Ml-element 2111a (oriented in the Y-direction) are not operated simultaneously. In this case, for example, an ac voltage can be applied over the nodes E1 and E2 while the excitation nodes E3 and E4 are left floating, in order to measure a magnetic field component Bx; and some time later, an ac voltage can be applied over the nodes E3 and E4 while the excitation nodes E1 and E2 are left floating, in order to measure a magnetic field component By, etc. The two Ml-elements may be alternatingly excited repeatedly.

In another embodiment, the first MI-element (oriented in the X-direction) and the second Ml-element (oriented in the Y-direction) are operated simultaneously. This can be achieved, for example, by electrically connecting the nodes E1 and E3, and by electrically connecting the nodes E2 and E4, and by applying an alternating voltage over the excitation nodes E1 and E2, and simultaneously or alternatingly sensing the nodes S1, S2 to measure a first current or a first impedance indicative of Bx, and sensing the nodes S3 and S4 to measure a second current or a second impedance indicative of By.

Other excitation schemes and readout schemes are possible.

In the example of FIG. 21, the excitation contact E1 and the sensing contact S1 coincide, but that is not absolutely required, as explained above. The same applies to the other excitation and sensing contacts E2, S2 and E3, S3 and E4, S4.

It is an advantage of this sensor structure that it allows to measure two orthogonal magnetic field components Bx, By. Depending on the application, this allows e.g. to determine an angular position relative to a magnet.

**FIG. 22** shows a sensor structure 2210 as can be used in embodiments of the present invention, comprising two elongated portions 2211a, 2211b oriented perpendicular to each other, and spaced apart from each other. The distance d22 may be a distance in the range from 50 µm to 500 µm. This sensor structure is a variant of the sensor structure of FIG. 21, and allows for the same measurements.

**FIG. 23** shows an example of another sensor structure 2310 that can be used in embodiments of the present invention. This sensor structure can be seen as a variant of the sensor structure of FIG. 21, further comprising a disk shaped portion at the center, and four horizontal Hall elements arranged near the periphery of that disk. Or stated in other words, this sensor structure 2310 has a shape with a central disk shaped portion, and four elongated portions (or arms) extending in four orthogonal directions. Preferably the elongated portions have a same length L1.

This sensor structure can be used to determine Bx by performing an impedance measurement between the excitation nodes E1, E2, and can be used to determine By by performing an impedance measurement between the excitation nodes E3, E4, as described in FIG. 21.

In addition, this sensor structure can be used to measure a magnetic field component Bu oriented in the U-direction, and a magnetic field component Bv oriented in the V-direction. The Hall elements may be operated (i.e. biased and readout) while the excitation nodes E1 to E4 and the sensing nodes S1 to S4 are left floating, or may be operated at the same time as performing an impedance measurement. In an embodiment, the measurement of the Ml-elements and the measurements of the Hall elements are not performed simultaneously, but are performed in a time-multiplexed manner.

It is an advantage of this structure that it allows to measure Bx and By with a first sensitivity (using the magneto-impedance measurement technique), and allows to measure Bu and Bv with a second sensitivity (using the Hall elements, and the disk shaped flux concentrator). The values of Bu and Bv can be converted into values for Bx and By, or vice versa, e.g. by using a matrix operation.

The same dimensions as mentioned in FIG. 18 are applicable here.

**FIG. 24** shows an example of another sensor structure 2410 that can be used in embodiments of the present invention. This sensor structure can be seen as a variant of the sensor structure of FIG. 4, wherein the sensing contacts S1, S2 are situated between the excitation contacts E1, E2; and wherein the sensor structure 2410 further comprises at least one Hall element, e.g. two Hall elements H1, H2 situated near the first gap g1 between the first trapezoidal shaped portion 2412a and the elongated portion 2411, and further comprises at least one Hall element, e.g. two Hall elements H3, H4 situated near the second gap g2 between the second trapezoidal shaped portion 2412b and the elongated portion 2411.

In a variant (not shown), the two Hall elements H1 and H2 are replaced by a first Hall element situated in the middle between H1 and H2, and the two Hall elements H3 and H4 are replaced by a second Hall element situated in the middle between H3 and H4. Using two Hall elements instead of only one improves the signal-to-noise ratio, when the signals are combined, e.g. averaged or summed.

The sensor structure 2410 allows to measure the magnetic field Bx by performing a magneto-impedance measurement using the MI element 2411, and allows to measure the magnetic field components Bx and Bz by means of the Hall elements. This allows a measurement of Bx over an extended range, and/or allows for error detection (e.g. by comparing the two Bx measurements).

**FIG. 25** shows an example of another sensor structure 2510 that can be used in embodiments of the present invention. This embodiment illustrates that the elongated portion 2511 can be magnetically biased using a planar coil 2505. By doing so, the curve of the magneto-impedance measurement as a function of the value Bx can be shifted, and the sensitivity of the magneto-impedance measurement can be improved. The planar coil can be implemented for example in the "interconnection stack", also known as "metal stack" of the semiconductor substrate 2500. It is noted in this respect that the "interconnection stack" 2503 of a standard CMOS device typically contains four metal layers. A planar coil 2505 can be provided by forming a spiral in one or more of these metal layers. **FIG. 25(a)** shows a top view, and **FIG. 25(b)** shows a cross-sectional view of such a semiconductor substrate.

In a variant (not shown), the sensor device further comprises a second coil, situated near the other end of the MI element 2511. The second coil may have the opposite polarity of the first coil 2505.

As described above, it is also possible to create a 3D loop surrounding the MI element 2511, e.g. using an RDL layer or bond-wires, or other known techniques.

**FIG. 26** shows a flow chart of a method 2630 of manufacturing a semiconductor substrate as described above, or a sensor device comprising such a semiconductor substrate. The method comprises the steps of:
a) providing in step 2631 a semiconductor substrate (e.g. CMOS substrate) comprising:
   - an excitation circuit for exciting a magneto-impedance element;
   - a sensing circuit for sensing a magneto-impedance element;
   - a processing circuit connected to the sensing circuit and configured for providing an output signal indicative of a measured impedance or a value derived therefrom (e.g. a magnetic field component Bx, a current, a torque, a position, a pressure);
b) optionally providing in step 2632 a buffer layer (e.g. a polyimide layer) on top of the semiconductor substrate;
c) making in step 2633 at least two openings through an upper layer (e.g. protection layer or buffer layer) of the semiconductor substrate, to form excitation contacts in electrical connection with the excitation circuit, and to form sensing contacts in electrical connection with the sensing circuit. As mentioned above, some of the excitation contacts and the sense contacts may coincide;
d) optionally applying 2634 an electrically conductive layer, e.g. a metal seed (e.g. Cu), e.g. by sputtering;
e) applying 2635 a soft-magnetic material (e.g. FeNi), e.g. by sputtering and/or electroplating, e.g. on top of the metal seed, if present.

Step e) may comprise sputtering a bulk layer of soft-magnetic material, or may comprise providing a stack of multiple layers of soft-magnetic material, and layers of another material in between.

Step d) may comprise: providing at least one seed layer having a shape with at least one elongated portion.

Step d) may comprise: providing two seed layers, e.g. including a first seed layer to ensure good adhesion (e.g. comprising Ti or a Ti alloy), and a second seed layer (e.g. Cu).

The method may further comprise step f) of annealing the soft magnetic material while applying a static magnetic field oriented in a direction parallel to the semiconductor substrate.

A step of annealing is not required, however, and it is also possible to create the so called "easy axis" by flowing a strong current in the MI structure(s).

The method may further comprise one or more of the following steps:
- dicing the semiconductor substrate to form a plurality of semiconductor dies;
- mounting the semiconductor die on a lead frame;
- packaging the semiconductor die by applying a moulding compound.

**FIG. 27** shows a flow chart of a method 2730 according to another embodiment of the present invention, which can be used to manufacture a semiconductor substrate as described above, e.g. as illustrated in FIG. 14A and FIG. 14B. The method of FIG. 27 can be seen as a special case of the method of FIG. 26. The method 2730 comprises the following steps:
a) providing 2731 a semiconductor substrate comprising: an excitation circuit for exciting a magneto-impedance element; a sensing circuit for sensing a magneto-impedance element; a processing circuit connected to the sensing circuit;
c) making 2733 at least two openings through an upper layer of the semiconductor substrate, to form excitation contacts (E1, E2) in electrical connection with the excitation circuit, and to form sensing contacts (S1, S2) in electrical connection with the sensing circuit;
g) providing 2737 "contact pads" in contact with the excitation contacts and with the sensing contacts;
b) providing 2732 a buffer layer (e.g. a polyimide layer) on top of the semiconductor substrate, and making two (relatively large) openings through the buffer layer, one at each end of the MI-structure, for contacting the "contact pads";
d) optionally applying 2734 an electrically conductive layer, e.g. a metal seed (e.g. Cu), e.g. by sputtering;
e) applying 2735 a soft-magnetic material (e.g. FeNi or an FeNi alloy), e.g. by sputtering and/or electroplating, e.g. on top of the metal seed, if present

Step c) and g) may be performed in a single "operation".

It is an advantage that the steps a), c) and g) can be performed using a standard CMOS process, using CMOS lithography.

The same remarks regarding step d), step f) and optional further steps is also applicable here.

It is noted that step 2737 and step 2837 are typically used in a CMOS process to form a bonding pad in the top metal of the "metal stack". The bonding pad is then routed to the excitation and/or sensing circuitry using the metal layers of the "metal stack".

**FIG. 28** shows a flow chart of a method according to another embodiment of the present, which can be used to manufacture a semiconductor substrate as described above, e.g. as illustrated in FIG. 15A to FIG. 15C. The method of FIG. 28 can be seen as another special case of the method of FIG. 26. The method 2830 comprises the following steps:
a) providing 2831 a semiconductor substrate comprising: an excitation circuit for exciting a magneto-impedance element; a sensing circuit for sensing a magneto-impedance element; a processing circuit connected to the sensing circuit;
c) making 2833 at least two openings through an upper layer of the semiconductor substrate, to form excitation contacts (E1, E2) in electrical connection with the excitation circuit, and to form sensing contacts (S1, S2) in electrical connection with the sensing circuit;
g) providing 2837 "contact pads" in contact with the excitation contacts and with the sensing contacts;
b) providing 2832 a buffer layer (e.g. a polyimide layer) on top of the semiconductor substrate, and making two (relatively large) openings through the buffer layer, one at each end of the MI-structure, for contacting the "contact pads";
d) optionally applying 2834 an electrically conductive layer, e.g. a metal seed (e.g. Cu), e.g. by sputtering;
h) providing 2838 a mask with openings for the electrically conductive material at certain envisioned locations of the Ml-element;
i) depositing 2839 an electrically conductive material (e.g. Cu) in the openings;
j) providing 2840 a mask over the electrically conductive material;
e) applying 2735 a soft-magnetic material (e.g. FeNi), e.g. by sputtering and/or electroplating, e.g. on top of the metal seed, if present

The same remarks regarding step d), step f) and optional further steps is also applicable here.

In an embodiment, the electrically conductive material (e.g. Cu) is provided before the soft-magnetic material is provided, but that is not absolute required, and it is also possible to first provide the soft-magnetic material, and the electrically conductive material (e.g. Cu) later.

Step e) may comprise: applying 2835 a soft-magnetic material on top of the seed layer and at least partially on top of the conductive material.

### REFERENCES:

- E1, E2: excitation contact
- S1, S2: sensing contact
- H1, H2: horizontal Hall element

### REFERENCES (module 100):

- 00: semiconductor substrate
- 01: excitation circuit
- 02: sensing circuit
- 03: "interconnection layers", "metal stack"
- 04: buffer layer
- 05: biasing coil
- 06: processing circuit
- 07: "biasing and readout" circuit for Hall elements
- 08: seed layer
- 10: sensor structure or sensor arrangement
- 11: elongated portion of MI structure, "Ml element"
- 12: trapezoidal portion
- 13: disk shaped portion
- 14: U-shaped portion
- 15: cavity
- 20: shielding
- 30: method
- 50: sensor device
- 51: contact pads
- 52: passivation layer or intermediate layer
- 53: passivation layer
- 54: buffer layer, e.g. polyimide layer
- 55: seed layer
- 56: contact surface (on a side of the MI element)

## Claims

1. A sensor device comprising:
- a semiconductor substrate (100) comprising an excitation circuit (101) for generating an alternating voltage or an alternating current, and a sensing circuit (102) for measuring magneto-impedance effect of a soft-magnetic component (111) arranged on top of the semiconductor substrate (100);
- wherein the soft-magnetic component (111) is operatively connected to both of said excitation circuit and said sensing circuit; and
- wherein the soft-magnetic component (111) is electrically connected to at least one of said excitation circuit and said sensing circuit by means of back contacts situated at a bottom surface of the soft-magnetic component (111), and/or by means of side contacts situated near (at?) a lateral surface of the soft magnetic component (111);
- wherein the soft-magnetic component has an elongated shape extending in a first direction (X) parallel to the semiconductor substrate (100), or has a shape comprising at least one elongated portion extending in a first direction (X) parallel to the semiconductor substrate (100);
- a processing circuit (506) connected to the sensing circuit (102), and configured for providing a signal indicative of the magneto-impedance effect or a value derived therefrom.

2. A sensor device according to claim 1,
wherein the excitation circuit (101) is electrically connected to the soft-magnetic component (111) at a first and a second excitation contact (E1, E2); and
wherein the sensing circuit (102) is electrically connected to the soft-magnetic component (111) at a first and a second sensing contact (S1, S2).

3. A sensor device according to claim 2,
wherein the first excitation contact (E1) coincides with the first sensing contact (S1) and the second excitation contact (E2) coincides with the second sensing contact (S2);
or wherein the first and the second sensing contact (S1, S2) are situated between the first and the second excitation contact (E1, E2).

4. A sensor device according to any of the previous claims,
wherein the semiconductor substrate further comprises a buffer layer; and
wherein the soft-magnetic component is arranged on top of this buffer layer.

5. A sensor device according to claim 4,
wherein the excitation circuit and the sensing circuit are electrically connected to the soft-magnetic component by means of electrical interconnections passing through the buffer layer.

6. A sensor device according to any of the previous claims,
wherein the elongated shape or the elongated portion has a length L and a width W parallel to the semiconductor substrate, and a thickness T perpendicular to the semiconductor substrate;
wherein at least one of the ratios L/W and T/W is a value in the range from 2 to 100.

7. A sensor device (1010) according to any of the previous claims,
further comprising a second soft-magnetic component (1011b) also having an elongated portion extending in said first direction (X);
and wherein both soft-magnetic components are excited synchronously;
and wherein output signals from the soft-magnetic components are combined and indicative of a gradient signal.

8. A sensor device (1110; 1210; 1310) according to claim 6 or 7,
further comprising a magnetic shielding (1120; 1220; 1320) that is partially surrounding or completely surrounding the second soft-magnetic element (1111a; 1211a; 1311a), but not in direct physical contact with the first or second soft-magnetic element.

9. A sensor device (2510) according to any of the previous claims,
further comprising biasing means (2505) for generating a DC magnetic field in the soft-magnetic element.

10. A sensor device according to any of the previous claims,
wherein the soft-magnetic component has a cross-section with rounded or truncated edges or corners.

11. A sensor device according to any of the previous claims,
wherein the semiconductor substrate further comprises two soft-magnetic trapezoidal shapes (312a, 312b) arranged near opposite ends (A, B) of the soft-magnetic element (310).

12. A sensor device according to any of the previous claims,
wherein the semiconductor substrate (1600) further comprises at least two horizontal Hall elements (H1, H2);
and wherein the semiconductor substrate further comprises a biasing and readout circuit for biasing and reading out these Hall elements;
and wherein said horizontal Hall elements are arranged in one of the followings ways:
i) near the ends (A, B) of said soft-magnetic element (1611);
ii) near a middle of the soft-magnetic element, on opposite transversal sides of the soft-magnetic component;
iii) near two soft-magnetic trapezoidal shapes arranged near opposite ends of the soft-magnetic element.

13. A sensor device according to any of the previous claims,
further comprising an integrated magnetic concentrator (IMC) made of a soft-magnetic material;
and wherein the semiconductor substrate comprises a plurality of horizontal Hall elements arranged near a periphery of this IMC.

14. A method (2630) of producing a semiconductor substrate ( comprising the steps of:
a) providing (2631) a semiconductor substrate (100; 200; 500; 1400; 2200) comprising:
- an excitation circuit (101; 201; 501; 1401) for exciting a magneto-impedance element;
- a sensing circuit (102; 202; 502; 1402) for sensing a magneto-impedance element;
- a processing circuit (506) connected to the sensing circuit (102), and configured for providing a signal indicative of the magneto-impedance effect or a value derived therefrom;
b) optionally providing (2632) a buffer layer (104; 204; 504; 1404) on top of the semiconductor substrate;
c) making (2633) at least two openings through an upper layer of the semiconductor substrate, to form excitation contacts (E1, E2) in electrical connection with the excitation circuit (101), and/or to form sensing contacts (S1, S2) in electrical connection with the sensing circuit (102);
d) optionally applying (2634) an electrically conductive layer, e.g. a metal seed layer;
e) applying (2635) a soft-magnetic material, e.g. by sputtering and/or by electroplating.

15. Method (2630) according to claim 14, further comprising one of more of the following features:
- wherein the semiconductor substrate provided in step a) is a CMOS substrate;
- wherein the semiconductor substrate provided in step a) further comprises at least two horizontal Hall elements, and biasing and readout circuitry for biasing and sensing these horizontal Hall elements;
- wherein the semiconductor substrate provided in step a) further comprises a non-volatile memory (507) operatively connected to said processing circuit (506);
- wherein the method further comprises: forming two trapezoidal portions of said soft-magnetic material, these trapezoidal portions being integrally formed with, or at a non-zero distance from the elongated portion;
- wherein the method further comprises: forming a disk shaped portion of said soft-magnetic material, this disk shaped portion being integrally formed with, or at a non-zero distance from the elongated portion;
- wherein the excitation contacts (E1, E2) coincide with the sensing contacts (S1, S2);
- wherein the sensing contacts (S1, S2) are situated between the excitation contacts (E1, E2);
- wherein the semiconductor substrate provided in step a) further comprises a buffer layer on top of the semiconductor substrate;
wherein the elongated portion has a length L and a width W parallel to the semiconductor substrate, and wherein the ratio L/W is a value in the range from 2 to 100;
wherein the elongated portion has a length L and a thickness T perpendicular to the semiconductor substrate, and wherein the ratio L/T is a value in the range from 2 to 100;
wherein at least two shapes having an elongated portion are formed in step d);
wherein at least two shapes having an elongated portion are formed in step d), and wherein one of these shapes is at least partially surrounded by a magnetic shielding;
- wherein the semiconductor substrate further comprises a planar coil, having a plurality of windings routed below the elongated portion;
- further comprising a step of wet etching or anisotropic etching after applying the soft-magnetic material, in order to provide rounded or truncated ends and/or edges;
- wherein the method further comprises a step f) of annealing (2636) the soft magnetic material while applying a static magnetic field oriented in a direction parallel to the semiconductor substrate;
- wherein the method further comprises a step of creating an easy magnetization axis by flowing a relatively large current through the soft-magnetic element.
